# EUROPEAN PATENT APPLICATION

(11) **EP 3 859 354 A1**
(43) Date of publication of application: **04.08.2021**
(21) Application number: 20154950.8
(22) Date of filing: 31.01.2020
(51) Int. Cl.: G01Q 70/10, G01Q 70/14

(54) **A DIAMOND SCANNING PROBE, ESPECIALLY FOR IMAGING APPLICATION, AND A METHOD FOR ITS FABRICATION**

(71) Applicant: Universität Basel, 4003 Basel (CH)
(72) Inventor: SHIELDS, Brendan, 4057 Basel (CH); HEDRICH, Natascha, 4052 Basel (CH)
(74) Representative: Kleine, Hubertus

(57) **Abstract**

A diamond scanning element (1), especially for an imaging application, comprising a support (5) and a pillar (8) extending from said support (5), wherein the pillar (8) is provided with a longitudinal axis (X) and wherein the pillar (8) comprises a tip (1) with a tapered lateral section (3) with a, preferably constantly, increasing curvature, wherein the tip (1) is further provided with a sensor element and with a flat end facet (4) extending toward the axis (X) with a gradient of less than 10%; and a method for the fabrication of a diamond scanning element.

## Description

### Technical Field

The current invention relates to a diamond scanning probe, especially for imaging application, and a method for its fabrication

Modern material systems, for example those of interest in spintronics, have created a need for imaging techniques with high sensitivity and high spatial resolution. Within this field, the nitrogen-vacancy (NV) center in diamond, particularly when integrated into a scanning probe-based quantum sensor, has attracted much attention due to its high magnetic field sensitivity and spatial resolution on the tens of nanometer scale. These two properties have allowed for the measurement of nanoscale systems such as skyrmions, antiferromagnetic domains, single neuron action potentials and magnetism in 2D materials. This wide range of applications highlights the versatility of the NV center, which can be implemented in a variety of systems and operating temperatures from ambient conditions to cryogenics. The essential requirements of such an NV-based nanoscale sensor are as follows. Firstly, an NV center in close proximity to the diamond surface, to minimize NV-sample separation and thus optimize spatial resolution while enhancing the detected magnetic signal from nanoscale sample volumes. Secondly, a high flux of de- tected photons for best sensitivity. The high refractive index of the diamond host (n=2.4) presents a challenge for the second requirement, but also offers a natural route to engineer photonic structures to maximize collection efficiency. Many approaches have been taken to optimizing collection efficiency via photonic engineering of diamond, including solid immersion lenses, periodic nanostructuring, dielectric antennas, parabolic reflectors, and waveguiding structures. However, for imaging applications, these approaches have typically suffered from large implantation depths of the NV center, or in the case of traditional scanning probes, non-optimized structures leading to low collection efficiencies. The inventive diamond probe can be used in all the aforementioned applications.

### Background Art

The state-of-the art technology in this field has focused thus far on diamond scanning probes with tapered side walls created by a similar electron beam lithography mask and etching with oxygen *(see* A. Jenkins, M. Pelliccione, G. Yu, X. Ma, X. Li, K. L. Wang, and A. C. Bleszynski Jayich, Single-spin sensing of domain-wall structure and dynamics in a thin- film skyrmion host, Phys. Rev. Mat. 3, 8 (2019*))* and O₂/Ar chemistry *(see* Y. Dovzhenko, F. Casola, S. Schlotter, T. X. Zhou, F. Büttner, R. L. Walsworth, G. S. D. Beach, and A. Yacoby, Magnetostatic twists in room-temperature skyrmions explored by nitrogen-vacancy center spin tex- ture reconstruction, Nature Comm. 9, 1 (2018*)).* Occasionally, CF₄ is introduced to remove residue, but not to produce a curved surface.

Furthermore, alternate masks, such as Aluminum *(see:* I. Gross, W. Akhtar, A. Hrabec, J. Sampaio, L. J. Martinez, S. Chouaieb, B. J. Shields, P. Maletinsky, A. Thiaville, S. Rohart, and V. Jacques, Skyrmion morphology in ultrathin magnetic films, Phys. Rev. Mat. 2, 2 (2018*))* have been used in combination with O₂/CF₄ dry etching to create diamond nanopillar arrays with straight or tapered walls.

Further prior art relating to the aforementioned application:
Q. Jiang, Large scale fabrication of nitrogen vacancy-embedded diamond nanostructures for single-photon source applications, Chinese Physics B, 25, 11 (2016*).*
Q. Jiang, Focused-ion-beam overlay-patterning of three-dimensional diamond structures for advanced single photon properties, Journal of Applied Physics, 116, 044308 (2014*).*
Momenzadeh, S.A, Nanoengineered diamond waveguide as a robust bright platform for nanomagnetometry using shallow nitrogen vacancy centers, Nano Letters, 15, 1 (2015*).*
Wan, N.H. Efficient extraction of light from a nitrogen-vacancy center in a diamond parabolic reflector. Nano Letters, 18, 5 (2018*).*
The US 2018/0246143 A1 and WO 2018/16997 A1 should also be cited as state of the art.

### Object of the invention

It is one object of the current invention to provide a scanning element with high collection efficiency and to minimize the depth of the defect.

A second object of the current invention is a method for manufacturing a scanning element, where the control of the design is achieved during the etching process.

### Disclosure of the invention

The object is achieved by a diamond scanning element with the features of claim 1 and a diamond scanning element with the features of claim 7.

The inventive diamond scanning element can be suitable for the use in an imaging application. It comprises a support and a pillar extending from said support. Said support can be a diamond slab. The pillar is tapered and said tapered diamond pillar is preferably monolithically attached at its base to said diamond slab.

The pillar is provided with a longitudinal axis and the pillar further comprises a tip with a tapered lateral section with a, preferably constantly, increasing curvature. The curvature might preferably have the form of a paraboloidal section. The a range of taper angles comprised the curvature can preferabyl be in the range of 12-50 degree.

The tip is further provided with a flat end facet, also referred to as a tapered end facet, extending at least toward the axis (X), with a gradient of less than 10%. The flat end facet might be plane, in which case the gradient is 0%. The gradient should be preferably less than 8%, more preferably less than 5 % and even more preferably less than 2%.

A gradient of 100% would define an angle of 90°, which would be a surface parallel to the longitudinal axis of the pillar. At an gradient of less than 10% the flat facet can be tilted away from the plane perpendicular to the axis by an angle of preferably less than 9 degrees.

The flat facet at the end is essential in order to minimize the distance between the tip and preferably of the defect at the tip, which is considered as a sensor element in the context of the current invention, and the sample to be measured.

The diamond scanning element can be considered as a sensor in the context of the current invention

The curvature, also referred to by an increasing taper angle towards the tip, is essential in order to achieve a high collection efficiency across a broad spectral band, without making the tip radius too large because larger tip radius impairs performance as a scanning probe.

Further embodiments are subject-matter of the dependent claims.

The said tapered end facet can have a preferred diameter of at least 30 nm, preferably at least 50 nm, more preferably between 100-300 nm.

The said tapered end facet can have a diameter which is at least 1 % of the length of the pillar. The length of the pillar can be less than 10.0 µm, preferably between 3.0 and 6.0 µm.

The tip, preferably the flat end facet, comprises said sensor element which is preferably a defect, more preferably a nitrogen-vacancy. Said defect can be positioned at center of the tip, especially at the center of the flat end facet.

The depth of the defect from the surface of the flat end facet can be less than 40 nm, preferably less than 25 nm.

In a preferred embodiment the pillar comprises a waveguide or can be designed as a waveguide. The diamond scanning element may further preferably comprise an aperture at the base of the pillar.

In a preferred embodiment of the invention the reflection occurs at normal incidence, or nearly normal incidence, to the backside, which minimizes the reflection. Alternatively or additionally, the backside of the slab could be coated with a film of material having an index of refraction less than 2.4, preferably close to 1.5, which could serve as an antireflection coating to minimize the reflection.

The divergence of said light could preferably be below the angle of total reflection for a diamond-air interface. Said angle of total reflection could preferably be about 24.5 degrees.

In the case of an NV-center as a defect the minimum aperture at the base of the pillar might be at least 0.8 µm.

At the tip of the diamond pillar, the rate of tapering can be steadily increased. The angle of tapering at the tip should be close to 45 degrees or more, in order to obtain a device that efficiently collects light from a broad band of wavelengths.

The taper does not continue to a radius of zero, but rather the tip radius is finite and may preferably be greater than approximately 50 nm.

As mentioned before, the defect, especially provided as a NV center, is placed in the tip of the pillar, at the focal point of the paraboloid and just inside the plane of the flat facet of the tip. The defect can also be misplaced offset from the focal point in any direction. In this case the device will still work but not as efficiently.

The defect is preferably sensitive to external fields produced by a sample that is brought in close proximity to the flat facet.

The invention further comprises a method for the fabrication of a diamond scanning element comprising a support and a pillar extending from said support, wherein the method comprises the following steps:
A: Providing a suitable diamond material
B: Deposition of a resist
C: Formation of an etch mask
D: Etching
wherein during the etching process, a first chemical compound is used that primarily attacks the diamond and thus forming a tapered conical pillar of diamond, and wherein during said etching process the mask is eroded by an addition of a second chemical compound to the first chemical compound.

In consequence the relative etch rate of the mask vs. the diamond is variably controlled by adjusting the etch chemistry. This distinguishes it from other methods for curved or angled surfaces and allows for much more control over the shape of the wall, beyond even the parabolic shape.

It is pointed out that the method can preferably be used for the fabrication of the inventive diamond scanning element. However also other designs can be realized with the current method of fabrication. Therefore, the method is not limited for the production of said inventive diamond scanning element only.

With the inventive method a range of angles up to 50 degrees can be achieved which is far more than known methods comprising the said method steps in the state of the art.

Preferred embodiments of the inventive method are subject matter of the dependent claims.

In a preferred embodiment step, A comprises the generation of a defect, preferably a nitrogen-vacancy, most preferably at the tip of the pillar, most preferably at center at the tip of the pillar.

The resist can preferably be an inorganic polymer layer, preferably formed by a flowable oxide material, most preferably Fox-16 by Dow Corning.

The formation of the etch mask in step C may be provided by an electron beam lithography.

The first chemical compound can preferably be O₂ and the second chemical compound can preferably be CF₄.

In a preferred embodiment of the method the amount of etching of mask material and/or diamond material during the formation of the diamond scanning element can be controlled by the ratio between the first and the second chemical compound which are added and/or adjusted during the etching process. Said ratio can be controlled and adapted by a control unit for controlling the dosage of each compound.

In step D the diamond can preferably be exposed to an Inductively Coupled Plasma, which causes the diamond to be etched in a Reactive Ion Etch process, wherein the reactive ions are formed from said first and second chemical compound.

The etching process can be controlled such that the inclination of the sidewalls of the mask is adapted to a 45 degree angle with a deviation of less than 5 degrees, preferably less than 2 degrees.

By control of the ratio between the first and the second chemical compound the range of angles, which are preferably etched in the diamond material for the formation of the tip, can be varied between 10 and 50 degrees, preferably between 12 and 50 degrees.

During the first part of the etch process, an etch chemistry, preferably O₂, is used that primarily attacks the diamond, forming a tapered conical pillar of diamond. The taper angle of this section is less than 12 degrees. Simultaneously the mask is eroded at the edge to form a trapezoidal cross section. The sidewalls of the mask are inclined at an approximately 45 degree angle (the angle need not be precisely 45 degrees, but should be substantially inclined from the vertical direction).

During the second part of the etch, the etch chemistry is modified by adding an agent that etches the mask material, preferably CF₄. By changing the concentration of CF₄ relative to O₂, the angle of the resulting diamond sidewall is changed.

Multiple CF₄:O₂ ratios can be used sequentially to obtain a curved surface profile. The range of angles we have achieved with this process is between 12 and 50 degrees.

### Brief Description of the drawings

Some advantageous embodiments for inventive diamond scanning element and an inventive embodiment of a method for fabrication are further explained in detail below together with drawings. Specific parts of the different embodiments can be understood as separate features that can also be realized in other embodiments of the invention. The combination of features described by the embodiment shall not be understood as a limitation for the invention:

### Mode for Carrying out the invention

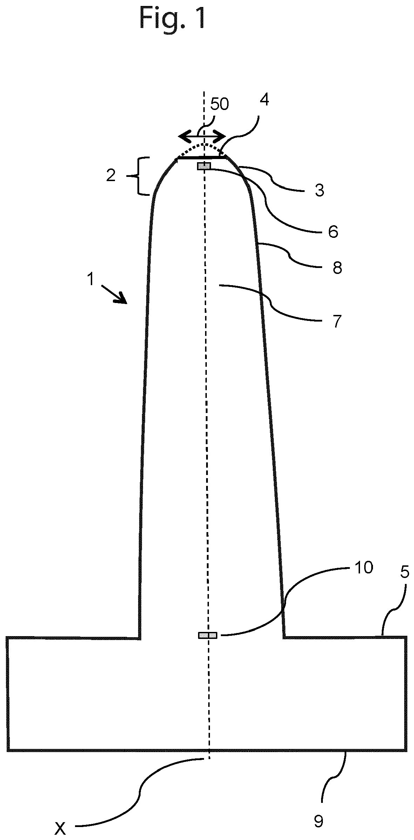

Fig. 1 shows an example for an inventive diamond scanning probe with a truncated parabolic profile, containing at least one single embedded nitrogen-vacancy (NV) center for nanoscale magnetic field imaging. Said probe is usually one of an array of similar designed probes.

The parabolic tip shape yields a median saturation count rate of 2.1MHz, the highest recorded count rate for scanning probes to date. At the same time, the structures remain highly broadband and produce directed emission.

Furthermore, the truncation shifts the diamond surface towards the focus of the parabola, allowing for small NV-sample spacings, which leads to ideal scanning conditions.

Said truncation can preferably be a distal flattening of the parabolic form of the tip. Said flattening of the probe at the tip may preferably be a planar surface. This geometry adapts to the concept of a diamond parabolic reflector in combination with a pillar slab geometry that was incorporated into an atomic force microscope probe for scanning magnetic field imaging.

Rather than using the typically cylindrical or tapered pillar structure, the current geometry of the tip of the probe consists of a diamond paraboloid with an NV at the focus. The truncated parabolic design comprises with a flat, preferably planar, end face, also referred to as a flat end facet, which minimizes the depth of the NV, and hence the distance to the sample.

The parabolic sides of said tip may define an imaginary parabolic plane, wherein said flat end facet preferably defines a planar surface perpendicular to the normal of said parabolic plane.

The geometry of the tip may provide total internal reflection at the parabolic surface which collimates the emission into a unidirectional output mode, resulting in improved waveguiding of the NV emission.

A further simulating of a cylindrical design was performed with a finite-difference time-domain solver (Lumerical), taking a cylindrical pillar waveguide as a basis of comparison.

Both cylindrical and parabolic devices have a facet diameter of 200 nm, approximately the minimal diameter that still supports an optical mode with strong confinement to the diamond. It was considered that dipoles are oriented both perpendicular (s-polarized) and parallel (p-polarized) to the pillar axis, and assess the device performance on the basis of two key metrics: outcoupled power Iₙₐ within the 0.8 numerical aperture cone of our objective (Iₙₐ) and directionality of emission. Note that Iₙₐ is related to the collection efficiency η of the parabolic reflector, but also includes the near-field effect of the parabolic surface and the Purcell effect due to reflection off the back side of the holding slab, which modify the radiative decay rate of the dipole. All powers are normalized to the power radiated by a dipole in uniform bulk diamond, I_{bd}.

As a result, an s-polarized dipole in the cylindrical device leads to a value of Iₙₐ/I_{bd} = 0.18 (averaged across the 630 nm to 800 nm NV emission band), while the same dipole in the parabolic device gives Iₙₐ/I_{bd} = 0.68. The nearly factor of four increase in waveguided emission shows the strength of the parabolic design, even when taking into account the interference due to the holding slab and exit aperture. To isolate the contribution of the parabola from this interference, a second simulation has been performed in which the waveguide section is terminated in the perfectly absorbing wall of the simulation space. The waveguided power I_{wg} was measured and it could be demonstrated that the parabolic design shows a consistently higher collected power over the NV emission band. If the actual fabricated device shown in Fig. 1 has been used in the simulation, we very similar results an ideal parabolic pillar has been observed.

A further full structure simulation has been performed to determine the far-field emission pattern for each device. By plotting the emission intensity as a function of polar angle, it has been observed that the larger aperture of the parabolic device concentrates the far field emission within a small numerical aperture (NA) of 0.25. The cylindrical pillar, on the other hand, due to its wavelength-scale aperture undergoes significant diffraction, resulting in a much larger NA = 0.65.

It has been noted that in the case of a p-polarized dipole (Fig. 1 (b), blue lines), outcoupled power is in all cases suppressed by a factor ≥ 7, due to the near-field diamond-air interface, and poor overlap with the waveguide mode. It is clear from these findings that an s-polarized dipole is optimal, which would be the case if the NV axis were aligned to the pillar axis.

For the development of the parabolic diamond tips, we begin with a high-purity type-Ila diamond (Element Six, [N]< 5 ppb, (100) surface), implanted with 2 × 10¹¹ cm^{-2 14} N at 12 keV and 7° tilt to the sample normal. The diamond is then annealed. More information for the annealing process can be found in the following document: Y. Chu, et al., Coherent optical transitions in implanted nitrogen vacancy centers, Nano Lett., 14, 4 (2014).

The anneling treatment will result in an estimated NV depth of 20 nm. ∼1-µm diameter discs where used, patterned via electron beam lithography in a ∼300- nm thick, flowable oxide resist (FOX-16, Dow-Corning) as an etch mask.

The following fabrication process then comprises of two dry-etching stages. The first, which is used to fabricate the waveguide portion, consists of an inductively coupled plasma reactive ion etch (ICP-RIE, Sentech) with primarily O₂ etch chemistry, and short steps of O₂ and CF₄ to clean off resputtered material from the walls of the device.

The two etch steps may be repeated a total of nine times to achieve a ∼6 µm pillar. At the end of this stage, the mask has a trapezoidal cross section with a base diameter of 900µm.

For the second stage, CF₄ was induced for the full duration of the etch at increasing flow rates for successive steps, which erodes the FOX mask in proportion to CF₄ concentration. This, along with the trapezoidal cross section, allows to tune the angle of the walls by controlling the relative etch rate of FOX mask and diamond. A typical final device is shown in Fig. 1 and has a parabolic tip section with a ∼ 200-nm flat end facet and a long tapered waveguide section. As previously mentioned, simulations of the final device profile indicate similar performance characteristics to the parabolic geometry. Note that the pillar is fabricated on a pre-etched 20 × 40 µm² diamond slab, which allows to easily attach the scanning probe to a quartz tuning fork for force feedback following established procedures, making this an easily scalable procedure.

Said established procedures can be derived from the following document: P. Appel, E. Neu, M. Ganzhorn, A. Barfuss, M. Batzer, M. Gratz, A. Tschöpe, and P. Maletinsky. Fabrication of all diamond scanning probes for nanoscale magnetome- try, Rev. Sci. Instrum. 87, 6 (2016).

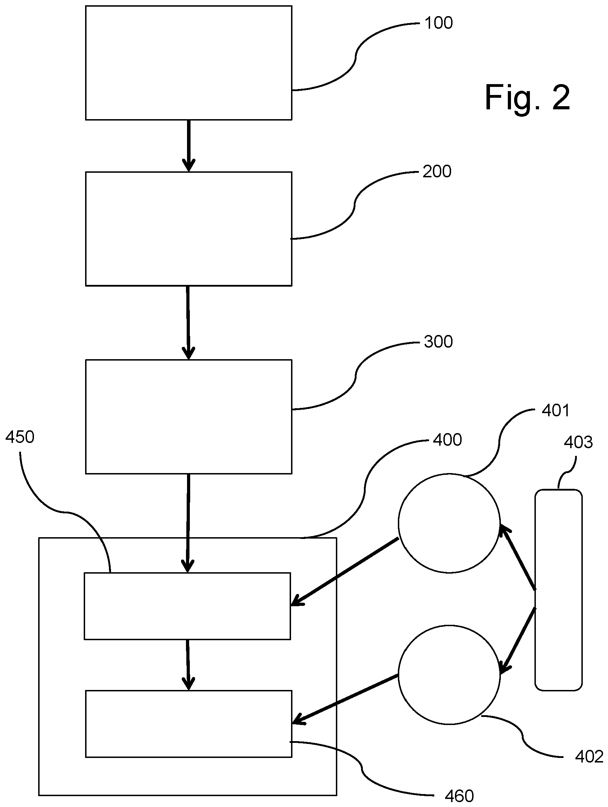

The different steps of fabrication are shown in Fig. 2.

The fabrication can be described as a method for the dry etching of curved surfaces in diamond.

The method can be described as following

### Step A: Providing a suitable diamond 100

A preparation of the surface, such as cleaning or other preparations may be included in this step. Also, the preparation of the defect at the surface may be included in the step A. In the case of an NV-defect - nitrogen is implanted to a controlled depth below the diamond surface and the diamond is annealed, forming NV centers.

### Step B: Deposition of an ebeam resist 200

As a preferred ebeam resist a flowable oxide mask can be used. A preferred material for such an oxide mask may be an inorganic polymer layer. Most preferred as material may be FOx-16 from Dow Corning in the composition delivered in the year 2019.

### Step C: Formation of the etch mask 300

An etch mask may be formed from the said layer by a treatment by the electron beam lithography such that the resist can be developed to form the etch mask.

### Step D: Etching 400

The diamond may be exposed to an inductively coupled plasma, which causes the diamond to be etched in a reactive ion etch process.

During the first part of the etch process, an etch chemistry, preferably O₂ 401, is used that primarily attacks the diamond, forming a tapered conical pillar of diamond. The taper angle of this section may preferably be less than 12 degrees.

Simultaneously the mask may be eroded at the edge to form a trapezoidal cross section.

The sidewalls of the mask are inclined at an approximately 45 degree angle. Note that the angle need not be precisely 45 degrees, but should be substantially inclined from the vertical direction.

During the second part of the etch, the etch chemistry is modified by adding an agent that etches the mask material, preferably CF₄ 402. By changing the concentration of CF₄ relative to O₂, the angle of the resulting diamond sidewall is changed.

Multiple CF₄:O₂ ratios can be used sequentially to obtain a curved surface profile. The range of angles achieved with this process can be between 10 and 50 degrees, preferably between 12 and 50 degrees. Said ratio can be controlled by a control unit 403 which can control the volume of CF₄ and/or O₂ introduced in the etching process.

The relative etch rate of the mask vs. the diamond is variably controlled by adjusting the etch chemistry. This distinguishes it from other methods for curved or angled surfaces, i.e. "grey-scale" lithography or mask erosion under fixed conditions. Therefore, the inventive method allows for much more control over the shape of the wall, beyond even the parabolic shape.

As mentioned above etching can be performed as a reactive ion etching of the mask in oxygen plasma to form an inclined cross-section at the edge of the mask, such that the mask tapers from a uniform thickness section to a point at the edge.

Said reactive ion etching of the mask can be provided with a combination of oxygen and CF4 plasma. The oxygen plasma primarily attacks the diamond, while the CF4 plasma primarily attacks the FOx-16 mask. Thus, by varying the relative concentration of oxygen vs. CF4, the angle of the wall of the diamond can be controlled. With such a technique it is possible to achieve angles between 10 degrees and 50 degrees.

The etching method allows for etching of curved surfaces, in particular for nano-optical devices.

This technique can be used for the fabrication of parabolic-shaped diamond scanning probes with flat end facets. It is possible to etch sidewalls with angles between 10 and 50 degrees from vertical, and by varying the concentration of gases during the etch curved surfaces can be obtained. By change of the concentration of the said gases the mask erosion can be controlled.

Various nanopillar shapes have been achieved through a combination of an electron beam lithography mask and oxygen etching, but without use of the mask erosion to control the angle of the etch.

The main alternative technique for producing curved surfaces is to create a greyscale mask (i.e. of varying thickness) by "reflowing" the resist after it is deposited. Reflow involves carefully heating the resist until it becomes fluid and forms a bubble on the sur- face. The resist is then etched, typically in a single etch step with uniform etch conditions, so that the curvature of the bubble is transferred into the substrate.
Within our search, we have found only one other resource in which the angle of diamond pillars within a large array is linked to a hard mask (such as what we use) erosion, while two techniques: one with a similar mask, and one with a lift-off procedure and Cr mask, both of which then use a CHF₃/O₂ etch chemistry. Here, they propose that the angle does appear due to the erosion of the mask, but only study the angle dependence on the pillar period and diameter.

The technique which has been described above is extendable to arbitrary geometries, although a further focus might be on a circularly symmetric geometries. Said technique relatively easy to implement in that it requires etching of a single mask.

For the production of the planar end facet, different techniques can be used. The produced diamond scanning probes have improved photonic performance relative to the existing commercially available scanning probes.

The scanning probes fabricated with this method collect data about 5-10 times faster than the existing probes thanks to an improved sensitivity resulting from the curvature of the diamond.

The effectiveness of the previously described parabolic tip with the planar surface can be shown for scanning magnetometry by performing measurements of an out-of plane magnetized ferromagnet, specifically a 1 nm thick, 0.73 µm wide stripe of CoFeB capped by a 5nm layer of Ta. A single scanning probe is mounted in a home-built confocal scanning setup and a small external field along the NV axis to split the spin states has been applied. Linescans were performed across the stripe, recording an ODMR spectrum every 20 nm. The frequency position of the lower ODMR resonance has been recorded, and thereby the field along the NV axis has been extracted by comparing it to the out-of-contact zero-field splitting.

Based on a fit of the measurement signals, one can extract a sample magnetization of (1.0 ± 0.2) mA and a separation of (45 ± 5) nm between the NV and the CoFeB stripe. Since the CoFeB is capped by a 5 nm layer of Ta, the effective separation between NV and Ta surface is (40 ± 5) nm is done. This provides an excellent spatial sensitivity.

In conclusion the parabolic diamond scanning probe containing single NV centers and demonstrated their use for nanoscale magnetic field imaging. The parabolic design is ideal for sensing applications, as it yields a high rate of detected photons from a near- surface NV. The devices could be further improved by incorporating an antireflection coating to the back surface of the slab, through the use of (111) oriented diamond to achieve optimal mode overlap with the NV optical transition dipoles, and better lateral NV placement via deterministic alignment to pre-selected NVs. The design is versatile and can be applied to many systems of interest, including scanning probe sensing of magnetic and electric fields or temperature, as well as NMR sensing of molecules or materials attached to the diamond surface.

The design of the inventive diamond scanning probe 1 according to Fig. 1 can be summarized such that it comprises a pillar 8 with an end section formed as a tip 2. A lateral section of this tip 2 may preferably be in the form of a truncated paraboloid and a flat, especially planar, end facet 4. Note that the planar form of the end facet is merely a preferred embodiment. Flat means that the end surface has a far smaller gradient then the lateral section. The gradient should be less than 10%, preferably less than 8%, more preferably less than 5 % with relation to a plane perpendicular to the longitudinal axis of the pillar 8.

The tip 2 can be preferably formed as a tapered diamond pillar preferably monolithically attached at its base to a diamond slab as a support 5.

At the tip of the diamond pillar, the rate of tapering is steadily increased, such that the profile of the pillar approximates a paraboloidal lateral surface 3. It is not strictly necessary that the shape be paraboloidal, but the rate of tapering should increase towards the tip. The angle of tapering at the tip should be close to 45 degrees or more, in order to obtain a device that efficiently collects light from a broad band of wavelengths.

The taper does not continue to a radius of zero, but rather the tip radius is finite and greater than approximately 50 nm. I.e. the tip of the pillar is a flat facet.

A defect 6 (NV center) is placed in the tip of the pillar, at the focal point of the paraboloid and just inside the plane of the flat facet of the tip. The defect can also be misplaced, offset from the focal point in any direction; the device will still work but not as efficiently.

The defect is sensitive to external fields, such as magnetic or electric fields, produced by a sample that is brought in close proximity to the flat facet.

The pillar constitutes a waveguide 7 for light emitted by the defect, and the base 5 of the pillar constitutes an aperture 10 through which the light emitted by the defect passes. The backside 9 of the diamond slab reflects this light, so the divergence of the light should be below the angle of total internal reflection for a diamond-air interface, preferably 24.3 - 24.7 degrees, more preferably about 24.5 degrees. For the NV center this implies a minimum aperture preferably between 0.9 and 1.1 µm, more preferably about 1 µm.

The flat facet at the end is provided in order to minimize the distance between the NV defect, which is the sensor and the sample to be measured.
Further to this the increasing taper angle towards the tip is provided in order to achieve a high collection efficiency across a broad spectral band, without making the tip radius too large because a larger tip radius impairs performance as a scanning probe.

### List of references

- 1: diamond scanning probe 1
- 2: tip
- 3: lateral section
- 4: end facet
- 5: support
- 6: defect
- 7: waveguide
- 8: pillar
- 9: backside
- 10: aperture

- 50: diameter of the end facet

- X: longitudinal axis

- 100: Step A
- 200: Step B
- 300: Step C
- 400: Step D
- 450: first Step of Etching
- 460: second Step of Etching
- 401: O₂
- 402: CF₄
- 403: Control unit

## Claims

1. Diamond scanning element (1), especially for an imaging application, comprising a support (5) and a pillar (8) extending from said support (5), wherein the pillar (8) is provided with a longitudinal axis (X) and wherein the pillar (8) comprises a tip (1) with a tapered lateral section (3) with a, preferably constantly, increasing curvature, wherein the tip (1) is further provided with a sensor element and wherein the tip (1) is provided with a flat end facet (4) extending toward the axis (X) with a gradient of less than 10%.

2. Diamond scanning element according to claim 1, **characterized in that** the said tapered end facet (4) has a diameter of at least 30 nm, preferably at least 50 nm, more preferably between 100-300 nm.

3. Diamond scanning element according to claim 1 or 2, **characterized in that** the said tapered end facet (4) has a diameter which is at least 1 % of the length of the pillar (8).

4. Diamond scanning element according to one of the preceding claims, **characterized in that** the tip (1), preferably the flat end facet (4), comprises said sensor element which is a defect (6), preferably a nitrogen-vacancy.

5. Diamond scanning element according to one of the preceding claims, **characterized in that** the defect (6) is preferably at center of the tip (1) and preferably with a depth of the defect from the surface of the flat end facet of less than 40 nm, preferably less than 25 nm.

6. Diamond scanning element according to one of the preceding claims, **characterized in that** the curvature of the tapered lateral section (3) of the tip (1) has the form of a paraboloidal section.

7. Method for the fabrication of a diamond scanning element comprising a support and a pillar extending from said support, wherein the method comprises the following steps:
A: Providing a suitable diamond material (100);
B: Deposition of a resist (200);
C: Formation of an etch mask (300);
D: Etching (400);
**characterized in that** during the etching process (400), a first chemical compound (401) is used that primarily attacks the diamond and thus forming a tapered conical pillar of diamond, and wherein during said etching process (400) a second chemical compound (402), that primarily attacks the mask material, is added to the first chemical compound (401).

8. Method according to claim 7, **characterized in that** step A (100) comprises the generation of a defect, preferably a nitrogen-vacancy, most preferably at the tip of the pillar, most preferably at center at the tip of the pillar.

9. Method according to claim 7 or 8, **characterized in that** the resist is an inorganic polymer layer, preferably formed by a flowable oxide material and wherein the formation of the etch mask in step C (300) is provided by an electron beam lithography.

10. Method according to one of the preceding claims, **characterized in that** the etching process (400) in step D is provided in two steps,
wherein in a first step of etching (450) said first chemical compound is used for forming a tapered conical pillar of diamond, preferably with taper angle of this section is less than 12 degrees, and
wherein, preferably simultaneously, the mask is eroded at the edge to form a trapezoidal cross section and
wherein in the second step of etching (460) the etch chemistry is modified by adding said second chemical compound (402) that etches the mask material such that angle of a resulting diamond sidewall is changed.

11. Method according to one of the preceding claims, **characterized in that** the first chemical compound (401) is O₂ and the second chemical compound (402) is CF₄.

12. Method according to one of the preceding claims, **characterized in that** in step D (400) the amount of etching of mask material and/or diamond material during the formation of the diamond scanning element is controlled by the ratio between the first and the second chemical compound (401, 402) which are adjusted during the etching process.

13. Method according to one of the preceding claims, **characterized in that** in step D (400) the diamond is exposed to an Inductively Coupled Plasma, which causes the diamond to be etched in a Reactive Ion Etch process, wherein the reactive ions are formed from said first and second chemical compound.

14. Method according to one of the preceding claims, **characterized in that** the etching process (400) is controlled such that the sidewalls of the mask are inclined at a 45 degree angle with a deviation of less than 5 degrees, preferably less than 2 degrees.

15. Method according to one of the preceding claims, **characterized in that** by control of the ratio between the first and the second chemical compound (401, 402) the range of angles etched in the diamond material for the formation of a tip during etching can be varied between 10 and 50 degrees, preferably between 12 and 50 degrees.
